# EUROPÄISCHE PATENTSCHRIFT

(11) **EP 4 091 062 B1**
(45) Veröffentlichungstag und Bekanntmachung des Hinweises auf die Patenterteilung: **11.09.2024**
(21) Anmeldenummer: 20824455.8
(22) Anmeldetag: 02.12.2020
(51) Int. Cl.: G06F 1/18, G05D 1/00, H05K 1/02, H05K 3/36, H05K 1/14, G06F 13/42, G06F 1/16, H04L 12/40, H05K 1/16, G06F 13/40

(54) **SENSORMODUL FÜR EIN MOBILTEIL, MOBILTEIL UND ANLAGE**
SENSOR MODULE FOR A MOBILE PART, MOBILE PART AND SYSTEM
MODULE CAPTEUR POUR UNE PIÈCE MOBILE, PIÈCE MOBILE ET SYSTÈME

(30) Priorität: 17.01.2020 DE 102020000266
(43) Veröffentlichungstag der Anmeldung: 23.11.2022
(73) Patentinhaber: SEW-EURODRIVE GmbH & Co. KG, 76646 Bruchsal (DE)
(72) Erfinder: MANZ, Friedrich, 76703 Kraichtal-Münzesheim (DE); KÖDDERITZSCH, Jan-Patrick, 76448 Durmersheim (DE); KÖPFER, Xaver, 76131 Karlsruhe (DE); STOCKENBERGER, Ulrich, 76694 Forst (DE)
(86) Internationale Anmeldenummer: PCT/EP2020/025555
(87) Internationale Veröffentlichungsnummer: WO 2021/143996

(56) Entgegenhaltungen:
- WO-A2-2006/051927
- DE-A1- 10 134 620
- GB-A- 1 373 503
- US-A- 5 239 868
- US-A1- 2019 141 818

## Beschreibung

Die Erfindung betrifft ein Sensormodul für ein Mobilteil, Mobilteil und Anlage

Es ist allgemein bekannt, dass Sensoren zur Erfassung von Werten physikalischer Größen verwendet werden.

**Aus der** US 4 530 056 A **ist ein automatisch geführtes Fahrzeugsystem bekannt.**

**Aus der** DE 10 2010 025 085 A1 **ist die Vorrichtung für ein Kraftfahrzeug bekannt.**

**Aus der** WO 2016/ 053 966 A2 **ist eine Temperaturregulierung mittels phasenwechselnder Materialien bekannt.**

**Aus der** DE 101 34 620 A1 **ist als nächstliegender Stand der Technik ein mehraxiales Inertialsystem bekannt.**

**Aus der** US 5 239 868 A **ist ein Winkelgeschwindigkeitsdetektionssystem bekannt.**

**Aus der** US 2019/141818 A1 **ist ein Steuermodul bekannt.**

**Aus der** WO 2006/051927 A1 **ist eine elektronische Anordnung bekannt.**

**Aus der** GB 1 373 503 A **ist ein Spurführungssystem bekannt.**

Der Erfindung liegt daher die Aufgabe zugrunde, eine robuste und kompakte Sensorik bei einem Mobilteil weiterzubilden,

Erfindungsgemäß wird die Aufgabe bei dem Sensormodul nach den in Anspruch 1, bei dem Mobilteil nach den in Anspruch **11** und bei der Anlage nach den in Anspruch 13 angegebenen Merkmalen gelöst.

Wichtige Merkmale der Erfindung bei dem Sensormodul für ein Mobilteil sind, dass innerhalb eines Gehäuses des Sensormoduls eine erste Leiterplatte mit einer zweiten Leiterplatte steckverbunden ist,
wobei die erste Leiterplatte einen ersten Sensor aufweist und die zweite Leiterplatte einen zweiten Sensor aufweist,
wobei die Sensorsignale des ersten Sensors und des zweiten Sensors einer Rechnereinheit zugeführt werden, welche mit einem ersten Datenbus-Anschluss des Sensormoduls, insbesondere Datenschnittstelle des Sensormoduls, verbunden ist.

Von Vorteil **ist bei der Erfindung,** dass die Sensorsignale von der Rechnereinheit zusammengefasst und über die Datenschnittstelle an eine andere Einheit weitergeleitet werden. Auf diese Weise ist nur eine Datenschnittstelle an der Oberfläche des Gehäuses zur Verfügung zu stellen. Trotzdem sind die vom jeweiligen Sensor erfassten Werte separierbar, da bei der Datenübertragung durch die Datenschnittstelle eine Kennzeichnung der Daten des jeweiligen Sensors ausführbar ist. Die Rechnereinheit ist darüber hinaus auch befähigt, die erfassten Werte auszuwerten und daraus Werte einer Stellgröße, wie beispielsweise den Lenkwinkel, zu bestimmen. Somit sind also Werte unterschiedlicher physikalischer Größen erfassbar mit einem einzigen Serisormodul.

Bei einer vorteilhaften Ausgestaltung ist der erste Sensor geeignet ausgebildet, Werte zumindest einer ersten physikalischen Größe zu erfassen,
wobei der zweite Sensor geeignet ausgebildet ist, Werte einer zweiten physikalischen Größe zu erfassen,
wobei die zweite physikalische Größe sich unterscheidet von der ersten physikalischen Größe. Von Vorteil ist dabei, dass das Sensormodul Werte von verschiedenen physikalischen Größen erfassbar macht.

**Erfindungsgemäß** ist die erste Leiterplatte senkrecht zur zweiten Leiterplatte ausgerichtet. Von Vorteil ist dabei, dass eine einfache Herstellung ermöglicht ist, insbesondere durch Steckverbinden, wenn die Leiterplatten mit einander entsprechenden Steckverbinderteilen bestückt werden. Somit ist eine kostengünstige, wenig arbeitsaufwändige Herstellung ermöglicht.

**Erfindungsgemäß** ist die zweite Leiterplatte mit einer dritten Leiterplatte steckverbunden, welche senkrecht zur zweiten Leiterplatte angeordnet ist,
wobei eine Leiterbahn der dritten Leiterplatte als Antenne eines Lesegeräts zum Auslesen eines insbesondere am Boden angeordneten RFID-Tags ausgeführt ist, insbesondere wobei die Signalelektronik des Lesegeräts auf der zweiten Leiterplatte angeordnet ist,
insbesondere wobei die dritte Leiterplatte einen geringeren Abstand zum Deckelteil aufweist als die erste Leiterplatte. Von Vorteil ist dabei, dass wiederum eine einfache Herstellung ermöglicht ist, wenn die Leiterplatten mit einander entsprechenden Steckverbinderteilen bestückt werden.

Bei einer vorteilhaften Ausgestaltung ist die erste Datenschnittstelle eine ETHERCAT-Schnittstelle. Von Vorteil ist dabei, dass ein Standard-Datenbus verwendbar ist, um die Daten, also die von den Sensoren erfassten Werte, an eine Auswerteeinheit zu übertragen zu übertragen.

Bei einer vorteilhaften Ausgestaltung ist die Rechnereinheit mit mindestens einem zweiten Datenbus-Anschluss des Sensormoduls verbunden, insbesondere mit mindestens einem Anschluss für CAN-Bus. Von Vorteil ist dabei, dass zusätzlich die vom jeweiligen Sensor erfassten Werte einer sicherheitsgerichteten Steuerung zugeleitet werden.

Bei einer vorteilhaften Ausgestaltung weist das Gehäuse ein insbesondere wannenförmiges Unterteil und ein darauf aufgesetztes Deckelteil, insbesondere plattenförmiges oder ebenes Deckelteil, auf,
wobei das Unterteil und das Deckelteil aus Kunststoff gefertigt sind, insbesondere jeweils als Kunststoffspritzgussteil gefertigt sind. Von Vorteil ist dabei, dass die Leiterplatten von einem aus Kunststoff gefertigten Gehäuse gehäusebildend und somit schützend umgeben sind. Dabei umgibt das Unterteil fünf Seiten, hat also nur zu einer Seite hin eine Öffnung, welche vom Deckelteil abgedeckt wird.

Bei einer vorteilhaften Ausgestaltung weist das Gehäuse ein metallisches insbesondere U-förmiges Gehäuseteil auf, welches am Unterteil anliegt,
insbesondere wobei das Gehäuseteil nur drei Seitenflächen des aus dem Unterteil und dem Deckelteil gebildeten im Wesentlichen quaderförmigen Gehäuses zumindest teilweise abdeckt und/oder berührt. Von Vorteil ist dabei, dass das Kunststoffgehäuse, insbesondere das Unterteil, zumindest an drei Seiten schützend umgeben ist.

Bei einer vorteilhaften Ausgestaltung ist das Gehäuseteil mit dem Unterteil stoffschlüssig verbunden. Von Vorteil ist dabei, dass eine direkte Anbindung ermöglicht ist und somit ein verbesserter Schutz erreichbar ist.

Erfindungsgemäß weist der zweite Sensor voneinander beabstandete Paare von Wicklungen auf,
wobei jedes Paar jeweils eine erste Wicklung und eine zweite Wicklung aufweist,
wobei die Wicklungsachse der ersten Wicklung senkrecht zur Wicklungsachse der zweiten Wicklung ausgerichtet ist
wobei der zweite Sensor ein Spurführungssensor ist. Von Vorteil ist dabei, dass der zweite Sensor als Spurführungssensor ausführbar ist für eine Anlage, in welcher das Mobilteil auf einem Boden verfahrbar ist, an oder in dem ein mit einem Strom beaufschlagter Primärleiter, insbesondere Hinleiter und Rückleiter eines als Stromschleife ausgeführten Primärleiters verlegt ist.

Bei einer vorteilhaften Ausgestaltung sind die zur zweiten Leiterplatte parallel ausgerichteten, ans Deckelteil angrenzenden oder das Deckelteil berührenden Seitenflächen des aus dem Unterteil und dem Deckelteil gebildeten, im Wesentlichen quaderförmigen Gehäuses nicht vom Gehäuseteil abgedeckt, insbesondere also nur gehäusebildend mittels des Unterteils geschützt,
wobei die ersten Wicklungen aus Leiterbahnen der zweiten Leiterplatte gebildet sind. Von Vorteil ist dabei, dass eine kostengünstige, wenig aufwändige Herstellung ermöglicht ist.

Bei einer vorteilhaften Ausgestaltung sind die zur zweiten Leiterplatte senkrecht ausgerichteten, ans Deckelteil angrenzenden oder das Deckelteil berührenden Seitenflächen des aus dem Unterteil und dem Deckelteil gebildeten, im Wesentlichen quaderförmigen Gehäuses nicht vom Gehäuseteil abgedeckt, insbesondere also nur gehäusebildend mittels des Unterteils geschützt,
wobei die zweiten Wicklungen aus Leiterbahnen der zweiten Leiterplatte gebildet sind. Von Vorteil ist dabei, dass ein von einem im Boden verlegten Primärleitersystem erzeugtes Magnetfeld im Wesentlichen ungedämpft eindringt in den vom Kunststoffgehäuse umgebenen Raumbereich. Somit ist eine Erfassung der Werte von Komponenten des Magnetfelds ermöglicht und davon abhängig eine Spurführung des Mobilteils ausführbar.

Bei einer vorteilhaften Ausgestaltung sind am Gehäuseteil Steckverbinderteile jeweils für Energie- und/oder Datenübertragung angeordnet, insbesondere wobei eines der Steckverbinderteile für ETHERCAT geeignet ausgebildet ist, insbesondere wobei eines der Steckverbinderteile für eine 24 Volt-Gleichspannungsversorgung geeignet ausgebildet ist,
insbesondere wobei zumindest ein weiteres Steckverbinderteil für CAN-Bus geeignet ausgebildet ist. Von Vorteil ist dabei, dass die Sensorsignale über die entsprechenden Datenschnittstellen an weitere Geräte, wie beispielsweise eine Sicherheitssteuerung zur Überwachung der von den Sensoren erfassten Werte, weiterleitbar sind. Außerdem sind die erfassten Werte auch an eine Steuerung weiterleitbar, welche den Lenkwinkel und die Geschwindigkeit des Mobilteils steuert.

**Erfindungsgemäß** ist der erste Sensor als Beschleunigungs- und Drehratensensor ausgeführt oder der erste Sensor weist zwei, auf der ersten Leiterplatte bestückte, senkrecht zur Fahrtrichtung des Mobilteils voneinander beabstandete, gegeneinander um 90° verdreht angeordnete Beschleunigungs- und Drehratensensoren auf.

**Erfindungsgemäß** ist der zweite Sensor ein Spurführungssensor. Von Vorteil ist dabei, dass ruckarme Bewegungen erreichbar sind und/oder der zeitliche Geschwindigkeits- oder Beschleunigungsverlauf auf einen Sollverlauf hin regelbar ist.

Bei einer vorteilhaften Ausgestaltung ist das Mobilteil auf einer Bodenfläche bewegbar,
wobei das Sensormodul an der Unterseite des Mobilteils angeordnet ist, insbesondere wobei das Deckelteil des Sensormoduls näher zur Bodenfläche hin angeordnet ist als das Unterteil und/oder als das Gehäuseteil.

Von Vorteil ist dabei, dass das Sensormodul zur Spurführung geeignet ausgeführt ist und auch zur Detektion von gekrümmt verlaufenden Fahrbahnen. Außerdem ist mittels des auf der zweiten Leiterplatte angeordneten RFID-Lesegeräts mit auf der dritten Leiterplatte angeordneter Antenne die Position innerhalb einer Anlage detektierbar.

Bei einer vorteilhaften Ausgestaltung ist am oder im Boden der Anlage ein Primärleiter verlegt,
insbesondere wobei der Primärleiter als langgestreckte Primärleiterschleife ausgeführt ist,
wobei ein als Hinleiter fungierender Teilbereich des Primärleiters parallel zu einem als Rückleiter fungierenden Teilbereich des Primärleiters verlegt ist,

insbesondere wobei der zweite Sensor zumindest drei Paare von Wicklungen aufweist und der Abstand von einem ersten der Paare zu einem zweiten der Paare dem Abstand von einem dritten der Paare zum zweiten der Paare gleicht,
wobei der Abstand zwischen dem ersten und dem dritten der Paare größer ist als der Abstand zwischen dem Hinleiter und dem Rückleiter.

Von Vorteil ist dabei, dass eine Spurführung in einfacher Weise ermöglicht ist, da das zweite Paar zwischen dem Hinleiter und Rückleiter positionierbar ist und die beiden anderen Paare außerhalb der den Hinleiter und Rückleiter umfassenden Primärleiterschleife.

Die Erfindung wird nun anhand von schematischen Abbildungen näher erläutert:
In der Figur 1 ist ein erfindungsgemäßes Sensormodul eines Mobilteils gezeigt, wobei das Sensormodul eine erste, eine zweite und eine dritte Leiterplatte (1, 2, 3) aufweist.
In der Figur 2 ist die zweite Leiterplatte 2 in ihrer Ausrichtung zu einem im Boden verlegten Primärleitersystem, das einen Hinleiter 20 und einen Rückleiter 21 aufweist, gezeigt.
In der Figur 3 ist die erste Leiterplatte 1 in ihrer Ausrichtung zur Fahrtrichtung des Mobilteils dargestellt.

Wie in den Figuren dargestellt, weist das Sensormodul ein wannenförmiges Unterteil 5 auf, auf welches das Deckelteil 4 aufgesetzt ist. In dem von dem Unterteil 5 und dem deckelteil 4 umgebenen Raumbereich sind die drei Leiterplatten (1, 2, 3) angeordnet.

Dabei sind die erste Leiterplatte 1 und die dritte Leiterplatte 3 zueinander parallel ausgerichtet. Die zwischengeordnete zweite Leiterplatte 2 ist senkrecht zu der ersten und zu der dritten Leiterplatte 3 ausgerichtet.

Die zweite Leiterplatte 2 ist einerseits steckverbunden mit der ersten Leiterplatte 1 und andererseits mit der dritten Leiterplatte 3. Somit ist eine schnelle und einfache Verbindung oder Demontage ermöglicht.

Das Deckelteil 4 und das wannenförmige Unterteil 5 sind beide aus Kunststoff ausgeführt, so dass Magnetfeldlinien eines im Boden verlegten Primärleitersystem möglichst ungestört in den Raumbereich eindringen und die zweite Leiterplatte durchdringen können.

Das aus dem vorzugsweise plattenförmigen Deckelteil 4 und dem wannenförmigen Unterteil 5 gebildete Gehäuse ist zwar geschlossen; jedoch ist zur Verbesserung der mechanischen Stabilität und des mechanischen Schutzes ein metallisches Schutzgehäuse, das als U-förmiges Gehäuseteil 6 ausgeführt ist, vorgesehen.

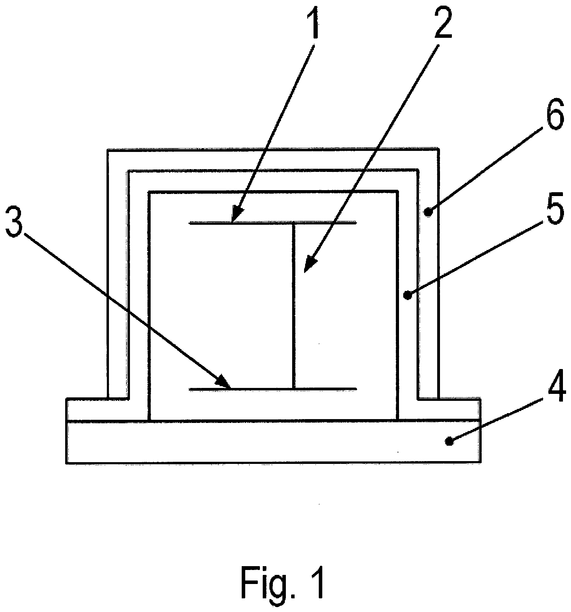

Dieses Schutzteil 6 weist einen U-förmigen Querschnitt auf, so dass es in Blickrichtung der Figur 1 vorne und hinten offen ist. Auf diese Weise dringen Magnetfelder ein und
durchdringen somit die zweite Leiterplatte 2, auf der Sensorwicklungen 23 angeordnet sind. Außerdem schützt das metallische Gehäuseteil 6 mit seinen Wänden an der langen Seite die Leiterplatte 2 vor unerwünschten Magnetfeldern (Streufeldern), während die Öffnungen an den kurzen Seiten den ungehinderten Eintritt der gewünschten Magnetfelder der erlauben.

Das metallische Gehäuseteil 6 umgreift das aus Unterteil 5 und Deckelteil 4 gebildete Kunststoffgehäuse nur an der in Fahrtrichtung 31 des Mobilteils Vorderseite und Rückseite.

Das Sensormodul ist vorzugsweise an der Unterseite eines Mobilteils angeordnet, so dass das Deckelteil 4 dem Boden zugewandt ist und am nahegelegendsten ist. Das metallische Gehäuseteil 6 ist somit weiter entfernt.

Das Kunststoffgehäuse ist im metallischen Gehäuseteil 6 aufgenommen und somit versteift und geschützt.

Die dritte Leiterplatte 3 ist somit die dem Boden 22 am nächsten gelegene der Leiterplatten (1, 2, 3). Auf der dritten Leiterplatte 3 ist daher eine Antenne eines Lesegeräts zum Auslesen von am Boden angeordneten RFIDs angeordnet.

Die Sensorwicklungen 23 weisen drei Paare auf, wobei jede der Sensorwicklungen 23 eine Vorzugsrichtung aufweisen, insbesondere also nicht kreisförmig oder quadratisch, sondern rechteckförmig oder elliptisch geformt sind. In der Vorzugsrichtung sind die Sensorwicklungen 23 also weiter ausgedehnt als senkrecht dazu.

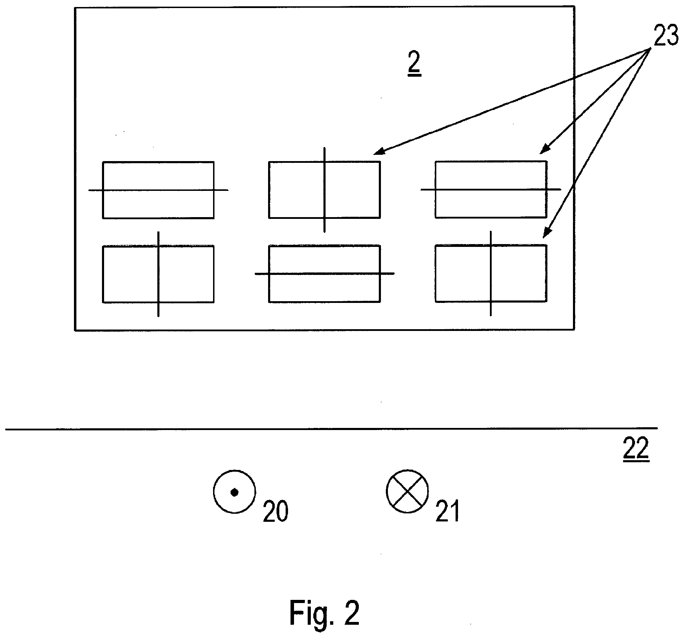

Wie in Figur 2 gezeigt, ist die Vorzugsrichtung einer ersten Sensorwicklung 23 eines jeweiligen Paars senkrecht zur Vorzugsrichtung der anderen Sensorwicklung 23 dieses jeweiligen Paars.

Die drei Paare sind in Querrichtung zur Fahrtrichtung also in einer Richtung parallel zur Bodenoberfläche, voneinander beabstandet angeordnet.

Der im oder am Boden 22 verlegte Hinleiter 20 ist parallel zu dem im oder am Boden 22 verlegten Rückleiter 21 ausgerichtet und weist einen stets gleichen Abstand auf. Der Hinleiter 20 und der Rückleiter 21 sind jeweils Teilbereich einer in der Anlage langgestreckt verlegten Primärleiterschleife.

Die in den Sensorspulen 23 induzierten Spannungen werden einer Rechnereinheit 30 zugeführt, welche das Mobilteil steuert, insbesondere die Fahrtrichtung mittels einer Lenkeinrichtung und die Geschwindigkeit mittels eines elektrischen Antriebs des Mobilteils.

Dabei wird die Fahrtrichtung von einem Regler der Rechnereinheit 30 derart gestellt, dass das mittlere Paar, also das in Querrichtung zwischen den beiden anderen Paaren angeordnete Paar mittig zum Hinleiter 20 und Rückleiter 21 angeordnet ist. Da der Abstand vom mittleren Paar zu dem jeweils anderen Paar jeweils größer ist als der Abstand zwischen dem Hinleiter 20 und dem Rückleiter 21 regelt die Rechnereinheit 30, insbesondere der Regler, das Mobilteil derart, dass das mittlere Paar in Querrichtung zwischen dem Hinleiter 20 und dem Rückleiter 21 angeordnet ist und die beiden anderen Paare außerhalb. Mit Querrichtung ist dabei eine Richtung innerhalb derjenigen Ebene gemeint, in der die Schwerpunkte der Paare angeordnet sind und welche parallel ausgerichtet ist zu derjenigen Ebene, welche den Hinleiter 20 und den Rückleiter 21 aufnimmt.

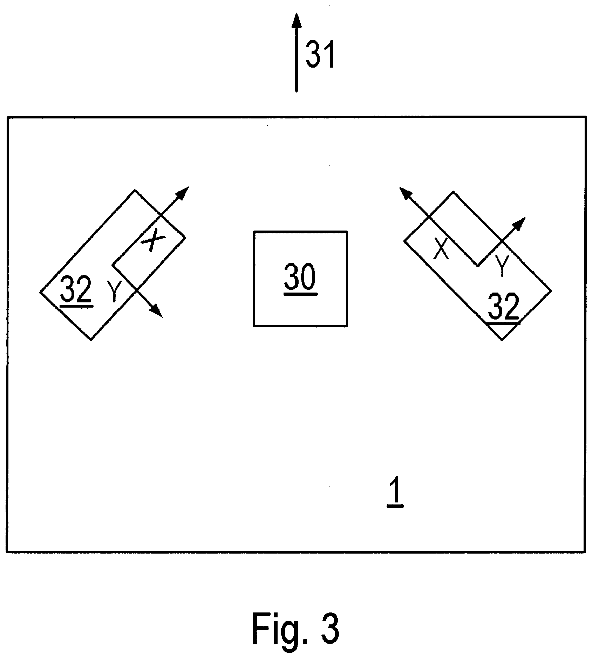

Wie in Figur 3 gezeigt, ist die erste Leiterplatte 1 auch mit zwei Beschleunigungssensoren 32, insbesondere Beschleunigungs- und Drehratensensoren, bestückt, die zueinander 90° verdreht sind. Somit ist der im Bereich des jeweiligen Beschleunigungssensors 32 wirkende Beschleunigungsvektor erfassbar. Nicht nur Abbremsvorgänge und Beschleunigungsvorgänge des Mobilteils, sondern auch Kurvenfahrten sind erkennbar. Darüber hinaus ist durch die Beschleunigungssensoren 32 auch eine sicherheitsgerichtete Erfassung ausführbar und somit eine höhere Sicherheitskategorie.

Die erfassten Werte der Antenne des Lesegeräts zum Auslesen einer Information eines im oder am Boden angeordneten RFID-Tags, der Beschleunigungssensoren 32 zur Erfassung der Beschleunigung des Mobilteils und der Sensorwicklungen 23 zur Spurführung des Mobilteils werden der Rechnereinheit 30 zugeführt, die die erfassten Daten auswertet und/oder über eine Datenschnittstelle, insbesondere ETHERCAT-Schnittstelle, herausgibt. Ein zugehöriges Steckverbinderteil ist am Gehäuseteil 6 angeordnet.

Somit sammelt die Rechnereinheit die erfassten Daten und bündelt diese, indem sie die erfassten Daten über die Schnittstelle herausgibt. Zusätzlich ist auch ein optischer Sensor zur Detektion einer an der Bodenoberfläche optisch gekennzeichneten Spur am Mobilteil befestigbar, dessen Signale ebenfalls der Rechnereinheit zugeführt werden, so dass die Rechnereinheit 30 diese dann über die Schnittstelle an einen mittels der Schnittstelle verbundenen Rechner herausleitet.

Die Sensorwicklungen 23 sind als Luftspulen ausgeführt.

Außerdem werden die erfassten Werte auch über zwei CAN-Bus-Schnittstellen bereitgestellt, die ebenfalls als Steckverbinderteil im Gehäuseteil 30 befestigt sind. Somit sind die Werte zweikanalig einer Sicherheitssteuerung zuführbar, welche die Signale überwacht, insbesondere auch auf Plausibilität überwacht und gegebenenfalls ein Warnsignal herausgibt und/oder eine Notabschaltung ausführt.

Bei weiteren erfindungsgemäßen Ausführungsbeispielen wird das Gehäuseteil 6 stoffschlüssig verbunden mit dem Unterteil 5, indem bei Herstellung das Gehäuseteil 6 mit hoher Temperatur auf das Unterteil aufgesetzt wird.

An der Unterseite des Mobilteils ist eine Sekundärwicklung angeordnet, die in Fahrtrichtung vom Sensormodul beabstandet ist.

### Bezugszeichenliste

1 erste Leiterplatte
2 zweite Leiterplatte
3 dritte Leiterplatte
4 Deckelteil
5 Unterteil, insbesondere wannenförmiges Unterteil
6 Gehäuseteil, insbesondere U-förmiges Gehäuseteil
20 Hinleiter
21 Rückleiter
22 Boden
23 Sensorwicklungen
30 Rechnereinheit
31 Fahrtrichtung
32 Beschleunigungssensoren

## Patentansprüche

1. Sensormodul für ein Mobilteil,
**wobei** innerhalb eines Gehäuses des Sensormoduls eine erste Leiterplatte mit einer zweiten Leiterplatte steckverbunden ist,
wobei die erste Leiterplatte einen ersten Sensor aufweist und die zweite Leiterplatte einen zweiten Sensor aufweist,
wobei die Sensorsignale des ersten Sensors und des zweiten Sensors einer Rechnereinheit zugeführt werden, welche mit einem ersten Datenbus-Anschluss des Sensormoduls,
insbesondere Datenschnittstelle des Sensormoduls, verbunden ist,
**dadurch gekennzeichnet, dass**
**die erste Leiterplatte senkrecht zur zweiten Leiterplatte ausgerichtet ist,**
**wobei die zweite Leiterplatte mit einer dritten Leiterplatte steckverbunden ist, welche senkrecht zur zweiten Leiterplatte angeordnet ist und parallel zur ersten Leiterplatte ausgerichtet ist,**
**wobei eine Leiterbahn der dritten Leiterplatte als Antenne eines Lesegeräts zum Auslesen eines am Boden angeordneten RFID-Tags ausgeführt ist,**
**wobei der erste Sensor als Beschleunigungssensor ausgeführt ist oder** wobei **der erste Sensor zwei, auf der ersten Leiterplatte bestückte, senkrecht zur Fahrtrichtung des Mobilteils voneinander beabstandete, gegeneinander um 90° verdreht angeordnete Beschleunigungssensoren aufweist,**
**wobei der zweite Sensor ein Spurführungssensor ist,**
**wobei der zweite Sensor voneinander beabstandete Paare von Wicklungen aufweist.**

2. Sensormodul nach Anspruch 1,
**dadurch gekennzeichnet, dass**
der erste Sensor geeignet ausgebildet ist, Werte zumindest einer ersten physikalischen Größe zu erfassen,
wobei der zweite Sensor geeignet ausgebildet ist, Werte einer zweiten physikalischen Größe zu erfassen,
wobei die zweite physikalische Größe sich unterscheidet von der ersten physikalischen Größe.

3. **Sensormodul nach einem der vorangegangenen Ansprüche,**
**dadurch gekennzeichnet, dass**
**die Signalelektronik des Lesegeräts auf der zweiten Leiterplatte angeordnet ist.**

4. **Sensormodul nach** Anspruch 3,
**dadurch gekennzeichnet, dass**
**die dritte Leiterplatte einen geringeren Abstand zum Deckelteil aufweist als die erste Leiterplatte.**

5. Sensormodul nach einem der vorangegangenen Ansprüche,
**dadurch gekennzeichnet, dass**
die erste Datenschnittstelle eine ETHERCAT-Schnittstelle ist.

6. Sensormodul nach einem der vorangegangenen Ansprüche,
**dadurch gekennzeichnet, dass**
die Rechnereinheit mit mindestens einem zweiten Datenbus-Anschluss des Sensormoduls verbunden ist, insbesondere mit mindestens einem Anschluss für CAN-Bus.

7. Sensormodul nach einem der vorangegangenen Ansprüche,
**dadurch gekennzeichnet, dass**
das Gehäuse ein insbesondere wannenförmiges Unterteil und ein darauf aufgesetztes Deckelteil, insbesondere plattenförmiges oder ebenes Deckelteil, aufweist,
wobei das Unterteil und das Deckelteil aus Kunststoff gefertigt sind, insbesondere jeweils als Kunststoffspritzgussteil gefertigt sind.

8. Sensormodul nach einem der vorangegangenen Ansprüche,
**dadurch gekennzeichnet, dass**
am Gehäuseteil Steckverbinderteile jeweils für Energie- und/oder Datenübertragung angeordnet sind.

9. Sensormodul nach Anspruch 8,
**dadurch gekennzeichnet, dass**
eines der Steckverbinderteile für ETHERCAT geeignet ausgebildet ist.

10. Sensormodul nach Anspruch 8 oder 9, **dadurch gekennzeichnet, dass** eines der Steckverbinderteile für eine 24 Volt-Gleichspannungsversorgung geeignet ausgebildet ist,
wobei zumindest ein weiteres Steckverbinderteil für CAN-Bus geeignet ausgebildet ist.

11. Mobilteil mit Sensormodul nach einem der vorangegangenen Ansprüche,
**dadurch gekennzeichnet, dass**
das Mobilteil auf einer Bodenfläche bewegbar ist,
wobei das Sensormodul an der Unterseite des Mobilteils angeordnet ist.

12. Mobilteil nach Anspruch 11,
**dadurch gekennzeichnet, dass**
das Deckelteil des Sensormoduls näher zur Bodenfläche hin angeordnet ist als das Unterteil und/oder als das Gehäuseteil.

13. Anlage mit einem Mobilteil mit Sensormodul nach einem der vorangegangenen Ansprüche,
**dadurch gekennzeichnet, dass**
am oder im Boden der Anlage ein Primärleiter verlegt ist.

14. Anlage nach Anspruch 13,
**dadurch gekennzeichnet, dass**
der Primärleiter als langgestreckte Primärleiterschleife ausgeführt ist, wobei ein als Hinleiter fungierender Teilbereich des Primärleiters parallel zu einem als Rückleiter fungierenden Teilbereich des Primärleiters verlegt ist.

15. Anlage nach Anspruch 14,
**dadurch gekennzeichnet, dass**
der zweite Sensor zumindest drei Paare von Wicklungen aufweist und der Abstand von einem ersten der Paare zu einem zweiten der Paare dem Abstand von einem dritten der Paare zum zweiten der Paare gleicht,
wobei der Abstand zwischen dem ersten und dem dritten der Paare größer ist als der Abstand zwischen den Hinleiter und dem Rückleiter.

## Claims

1. Sensor module for a mobile part,
wherein, within a housing of the sensor module, a first circuit board is plug-connected to a second circuit board,
wherein the first circuit board has a first sensor and the second circuit board has a second sensor,
wherein the sensor signals of the first sensor and of the second sensor are fed to a computer unit, which is connected to a first databus connection of the sensor module, in particular data interface of the sensor module,
**characterized in that**
the first circuit board is oriented perpendicular to the second circuit board,
wherein the second circuit board is plug-connected to a third circuit board, which is arranged perpendicular to the second circuit board and is oriented parallel to the first circuit board,
wherein a conductor track of the third circuit board is configured as an antenna of a reader for reading an RFID tag arranged on the ground,
wherein the first sensor is configured as an acceleration sensor, wherein or **in that** the first sensor comprises two acceleration sensors mounted on the first circuit board, said sensors being spaced apart from each other perpendicular to the direction of travel of the mobile part and being arranged in a manner rotated through 90° in relation to each other,
wherein the second sensor is a lane guidance sensor,
wherein the second sensor comprises spaced-apart pairs of windings.

2. Sensor module according to claim 1,
**characterized in that**
the first sensor is designed to be suitable for detecting values of at least one first physical variable,
wherein the second sensor is designed to be suitable for detecting values of a second physical variable,
wherein the second physical variable differs from the first physical variable.

3. Sensor module according to any one of the preceding claims,
**characterized in that**
the signal electronics of the reader are arranged on the second circuit board.

4. Sensor module according to claim 3,
**characterized in that**
the third circuit board is at a smaller distance from the cover part than the first circuit board.

5. Sensor module according to any one of the preceding claims,
**characterized in that**
the first data interface is an ETHERCAT interface.

6. Sensor module according to any one of the preceding claims,
**characterized in that**
the computer unit is connected to at least one second databus connection of the sensor module, in particular to at least one connection for a CAN bus.

7. Sensor module according to any one of the preceding claims,
**characterized in that**
the housing comprises an in particular trough-shaped lower part and a cover part placed thereon, in particular a plate-shaped or flat cover part,
wherein the lower part and the cover part are manufactured from plastic, in particular are each manufactured as an injection-moulded plastic part.

8. Sensor module according to any one of the preceding claims,
**characterized in that**
plug-in connector parts, each for transmitting power and/or data, are arranged on the housing part.

9. Sensor module according to claim 8,
**characterized in that**
one of the plug-in connector parts is designed to be suitable for ETHERCAT.

10. Sensor module according to claim 8 or 9, **characterized in that**
one of the plug-in connector parts is designed to be suitable for a 24 Volt DC power supply,
wherein at least one further plug-in connector part is designed to be suitable for a CAN bus.

11. Mobile part with a sensor module according to any one of the preceding claims,
**characterized in that**
the mobile part is movable on a ground surface,
wherein the sensor module is arranged on the underside of the mobile part.

12. Mobile part according to claim 11,
**characterized in that**
the cover part of the sensor module is arranged closer to the ground surface than the lower part and/or than the housing part.

13. System comprising a mobile part with a sensor module according to any one of the preceding claims,
**characterized in that**
a primary conductor is laid on or in the ground area of the system.

14. System according to claim 13,
**characterized in that**
the primary conductor is configured as an elongated primary conductor loop, wherein a portion of the primary conductor that acts as a forward conductor is laid parallel to a portion of the primary conductor that acts as a return conductor.

15. System according to claim 14,
**characterized in that**
the second sensor comprises at least three pairs of windings, and the distance from a first of the pairs to a second of the pairs is equal to the distance from a third of the pairs to the second of the pairs,
wherein the distance between the first and the third of the pairs is greater than the distance between the forward conductor and the return conductor.

## Revendications

1. Module détecteur destiné à une partie mobile,
une première plaquette à circuits imprimés étant connectée, par enfichage, à une deuxième plaquette à circuits imprimés à l'intérieur d'un boîtier dudit module détecteur,
ladite première plaquette à circuits imprimés étant munie d'un premier capteur, et ladite deuxième plaquette à circuits imprimés étant pourvue d'un second capteur,
les signaux de détection dudit premier capteur et dudit second capteur étant délivrés à une unité de calcul raccordée à une première connexion de bus de données du module détecteur, notamment à un interface de données dudit module détecteur,
**caractérisé par le fait que**
la première plaquette à circuits imprimés est orientée perpendiculairement à la deuxième plaquette à circuits imprimés,
laquelle deuxième plaquette à circuits imprimés est connectée, par enfichage, à une troisième plaquette à circuits imprimés qui est agencée perpendiculairement à ladite deuxième plaquette à circuits imprimés et est orientée parallèlement à la première plaquette à circuits imprimés,
une piste conductrice de la troisième plaquette à circuits imprimés étant réalisée sous la forme d'une antenne d'un appareil de lecture conçu pour lire une étiquette RFID située au sol,
sachant que le premier capteur est réalisé en tant que capteur d'accélération ; ou sachant que ledit premier capteur présente deux capteurs d'accélération implantés sur la première plaquette à circuits imprimés, distants l'un de l'autre perpendiculairement à la direction de déplacement de la partie mobile, et agencés avec décalage angulaire de 90° l'un par rapport à l'autre,
sachant que le second capteur est un capteur de guidage sur voies,
lequel second capteur comporte des paires d'enroulements distantes les unes des autres.

2. Module détecteur selon la revendication 1,
**caractérisé par le fait que**
le premier capteur est conçu pour se prêter à la détection de valeurs d'au moins une première grandeur physique,
le second capteur étant conçu pour se prêter à la détection de valeurs d'une seconde grandeur physique,
laquelle seconde grandeur physique diffère de ladite première grandeur physique.

3. Module détecteur selon l'une des revendications précédentes,
**caractérisé par le fait que**
l'électronique de signaux de l'appareil de lecture est implantée sur la deuxième plaquette à circuits imprimés.

4. Module détecteur selon la revendication 3,
**caractérisé par le fait que**
la troisième plaquette à circuits imprimés présente, par rapport à la partie formant couvercle, une distance moindre que celle de la première plaquette à circuits imprimés.

5. Module détecteur selon l'une des revendications précédentes,
**caractérisé par le fait que**
le premier interface de données est un interface EtherCAT.

6. Module détecteur selon l'une des revendications précédentes,
**caractérisé par le fait que**
l'unité de calcul est raccordée à au moins une seconde connexion de bus de données dudit module détecteur, notamment à au moins une connexion pour bus CAN.

7. Module détecteur selon l'une des revendications précédentes,
**caractérisé par le fait que**
le boîtier comprend une partie inférieure notamment en forme d'auge, et une partie formant couvercle, notamment une partie formant couvercle plane ou en forme de plaque, mise en place sur la partie précitée,
ladite partie inférieure et ladite partie formant couvercle étant fabriquées en matière plastique, notamment en tant que pièce respective en matière plastique venue de moulage par injection.

8. Module détecteur selon l'une des revendications précédentes,
**caractérisé par le fait que**
des pièces de connexion enfichable, respectivement affectées à la transmission d'énergie et/ou de données, sont implantées sur la partie formant boîtier.

9. Module détecteur selon la revendication 8,
**caractérisé par le fait que**
l'une des pièces de connexion enfichable est de réalisation à compatibilité EtherCAT.

10. Module détecteur selon la revendication 8 ou 9,
**caractérisé par le fait que**
l'une des pièces de connexion enfichable est d'une réalisation se prêtant à une alimentation par tension continue de 24 volts,
sachant qu'au moins une pièce supplémentaire de connexion enfichable est de réalisation à compatibilité bus CAN.

11. Partie mobile équipée d'un module détecteur conforme à l'une des revendications précédentes,
**caractérisée par le fait que**
ladite partie mobile peut être mue sur la surface d'un sol,
le module détecteur étant implanté à la face inférieure de ladite partie mobile.

12. Partie mobile selon la revendication 11,
**caractérisée par le fait que**
la partie formant couvercle du module détecteur est plus rapprochée de la surface du sol que la partie inférieure, et/ou que la partie formant boîtier.

13. Installation comportant une partie mobile équipée d'un module détecteur conforme à l'une des revendications précédentes,
**caractérisée par le fait**
**qu'**un conducteur primaire est posé sur, ou dans le sol de ladite installation.

14. Installation selon la revendication 13,
**caractérisée par le fait que**
le conducteur primaire est réalisé sous la forme d'une boucle allongée de conduction primaire, sachant qu'une région partielle du conducteur primaire, remplissant la fonction d'un conducteur d'arrivée, est posée parallèlement à une région partielle dudit conducteur primaire qui remplit la fonction d'un conducteur de retour.

15. Installation selon la revendication 14,
**caractérisée par le fait que**
le second capteur compte au moins trois paires d'enroulements, et la distance séparant une première paire, au sein desdites paires, d'avec une deuxième paire au sein desdites paires, est égale à la distance séparant une troisième paire, au sein desdites paires, d'avec ladite deuxième paire au sein desdites paires,
sachant que la distance, séparant lesdites première et troisième paires, au sein desdites paires, est supérieure à la distance comprise entre le conducteur d'arrivée et le conducteur de retour.
